**Europäisches Patentamt**

**European Patent Office**

**Office européen des brevets**

(11) Veröffentlichungsnummer : **0 519 089 B1**

(12) # EUROPÄISCHE PATENTSCHRIFT

(45) Veröffentlichungstag der Patentschrift :
**02.03.94 Patentblatt 94/09**

(51) Int. Cl.⁵ : **H03K 17/945, H03K 17/08**

(21) Anmeldenummer : **91109720.2**

(22) Anmeldetag : **13.06.91**

(54) **Einlesen von Betriebsparametern in einen funktionsbereiten Näherungsschalter.**

(43) Veröffentlichungstag der Anmeldung :
**23.12.92 Patentblatt 92/52**

(45) Bekanntmachung des Hinweises auf die
Patenterteilung :
**02.03.94 Patentblatt 94/09**

(84) Benannte Vertragsstaaten :
**CH DE FR GB IT LI**

(56) Entgegenhaltungen :
**EP-A- 0 313 162**
**DE-A- 3 608 639**

(56) Entgegenhaltungen :
**FR-A- 2 600 845**
**MESSEN PRUFEN AUTOMATISIEREN. Nr. 10,**
**Oktober 1988, BAD WORISHOFEN DE Seiten**
**509 - 511; SCHWAGER: 'Störschutz und Kur-**
**zschlussüberwachung für induktive Nähe-**
**rungsschalter'**

(73) Patentinhaber : **SIEMENS**
**AKTIENGESELLSCHAFT**
**Wittelsbacherplatz 2**
**D-80333 München (DE)**

(72) Erfinder : **Luber, Ernst, Dipl.-Ing. (FH)**
**Holnstein 5**
**W-8459 Neunkirchen (DE)**

**Beschreibung**

Die Betriebsparameter zum Betrieb eines Näherungsschalters können sich je nach Typ sowie aufgrund von Fertigungstoleranzen unterscheiden. Z.B. wird die Laufzeitauswertung eines Ultraschall-Näherungsschalters bisher im maskenprogrammierten Mikroprozessor von vielen Parametern bestimmt. Damit Fertigungstoleranzen bei den elektronischen Bauelementen und des Ultraschall-Wandlers ausgeglichen werden können, ist es von Vorteil, wenn die Betriebsparameter bis zum Einsatz des Ultraschall-Näherungsschalters variabel gehalten werden können. Eine derartige flexible Handhabung ermöglicht außerdem, daß auf Neuentwicklungen von Ultraschall-Wandlern und kundenspezifischen Lösungen für einen Ultraschall-Näherungsschalter reagiert werden kann.

Zur Lösung dieses Problems wurden bisher die Betriebsparameter im Programmspeicher eines maskenprogrammierten Mikroprozessors abgelegt. Hierzu wurden Lösungen mit Pullup-Widerständen am Mikroprozessor angewandt. Allerdings bestand hier der Nachteil, daß auf Neuentwicklungen am Ultraschall-Wandler und auf kundenspezifische Lösungen nur mit verhältnismäßig hohem schaltungstechnischen Aufwand reagiert werden konnte.

Zur Einstellung von Betriebsparametern ist es weiterhin bekannt (siehe Prospekt Ultraschall-Sensoren, Internationale Ausgabe '91 von Pepperl & Fuchs), bei Ultraschallsensoren Codierschalter im Klemmraum zu verwenden, wobei der Codierschalter dazu dient, vom Schaltausgang auf die serielle Schnittstelle umzuschalten, d.h. daß schaltungstechnisch für den kurzschlußfesten Schaltausgang und den benötigten Pegel für die serielle Schnittstelle Aufwand getrieben werden muß. Allerdings wird für diese Lösung zusätzlicher Verdrahtungsaufwand erforderlich, und weiterhin ist es von Nachteil, daß Raum benötigt wird, was z.B. beim Einsatz in Kompakt-Näherungsschaltern zu Problemen führt.

Der Erfindung liegt daher die Aufgabe zugrunde, und ein Verfahren anzugeben, mit demen ohne zusätzliche Raumerfordernisse eine wenig aufwendige Dateneingabe von Betriebsparametern in einen Mikroprozessor auch eines fertig zusammengebauten Näherungsschalters möglich ist, der einen Freigabeeingang aufweist. Hierbei wird von einem Näherungsschalter ausgegangen, der neben dem Eingang, der hier wegen seiner Funktion als Freigabeeingang bezeichnet ist, eine Überstrom-Überwachungseinrichtung mit einem Mikroprozessor enthält, dem über einen zugehörigen ersten Eingang durch einen Impuls ein Überstrom am Schaltausgang signalisiert werden kann. Die Lösung der Aufgabe ist im Anspruch 1 angegeben. Danach sind zum Laden Mittel vorgesehen, durch die ein derartiger Überstromzustand simuliert und der entsprechende Impuls erzeugt werden, der eine Information eines Betriebsparameters in Form eines Bitmusters repräsentiert, mit der der Mikroprozessor geladen wird, wobei der Freigabeeingang zur Synchronisierung des Mikroprozessors mittels ersten Synchronisierimpulsen benutzt ist.

Vorteilhafte Weiterbildungen des erfindungsgemäßen Verfahrens sind in den Ansprüchen 2 - 4 angegeben.

Eine Ausführungsform der Erfindung wird im folgenden anhand einer Zeichnung erläutert.

Es zeigen:

FIG 1  einen Ausschnitt eines Näherungsschalters mit einer Überstrom-Überwachungseinrichtung,

FIG 2  ein Bit-Muster für serielle Dateneingabe von Betriebsparametern,

FIG 3  einen Meßzyklus eines Ultraschall-Näherungsschalters,

FIG 4  ein Synchronisierimpulsraster zum Betrieb benachbarter Ultraschall-Näherungsschalter,

FIG 5  zwei über ihren Freigabeeingang durch eine gemeinsame Leitung verbundene Näherungsschalter,

FIG 6  ein Impulsdiagramm zur Prioritätenfestlegung bei serieller Synchronisation.

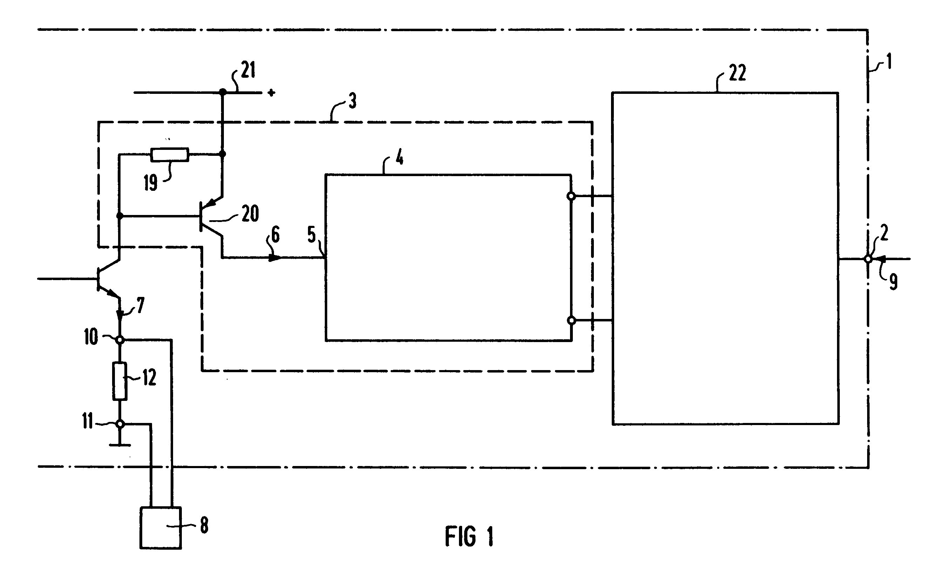

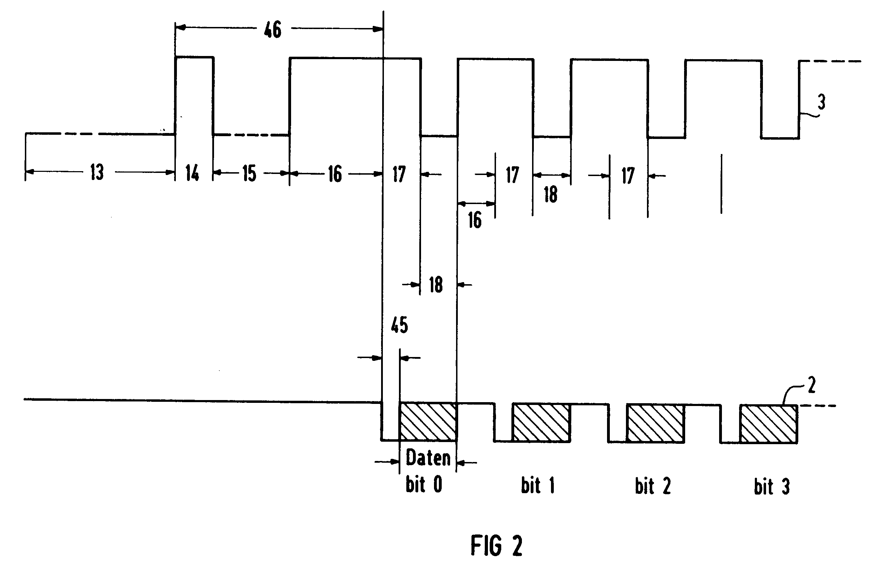

In FIG 1 ist eine Überstrom-Überwachungseinrichtung 3 eines Näherungsschalters 1 dargestellt, die einen Stromfühlerwiderstand 19, einen ersten Transistor 20 und einen Mikroprozessor 4 umfaßt. Die Überstrom-Überwachungseinrichtung 3 wird von einer ersten Spannungsquelle mit einem Potential 21 versorgt und ist über einen weiteren als Schaltausgang des Näherungsschalters dienenden Transistor an eine hier als ohmscher Widerstand 12 ausgeführte Last geschaltet. Zum Anschluß der Last 12 sind zwei Anschlüsse 10, 11 vorgesehen, die am Näherungsschalter 1 von außen her zuganglich sind. Für den Fall, daß die Last 12 durch das Programmiergerät niederohmig geschaltet wird, ergibt sich ein über den Stromfühlerwiderstand 19 und den Schaltausgang fließender Überstrom 7, der am Stromfühlerwiderstand 19 einen hierdurch erhöhten Spannungsabfall bewirkt. Dieser Spannungsabfall steuert den Transistor 20 an und hat zur Folge, daß das Potential 21 auf einen Eingang 5 des Mikroprozessors 4 durchgeschaltet wird, womit sich am Eingang 5 ein entsprechender Impuls 6 ergibt. Diese eigentlich nur für den Überstromfall vorgesehene Schutzeinrichtung wird erfindungsgemäß zur Dateneingabe von Betriebsparametern herangezogen. Hierzu wird ein Kurzschluß zwischen den Anschlüssen 10 und 11 mit Hilfe eines Programmiergerätes 8 simuliert. Für die Dauer der Programmierung ist der weitere, als Schaltausgang des Näherungsschalters verwendete Transistor durchgeschaltet. Zur Synchronisierung der Impulse 6 am ersten Eingang 5 des Mikroprozessors 4 werden dem Näherungsschalter 1 über seinen Freigabeeingang 2 erste Synchronisierimpulse 9 zugeführt. Der Aufbau der Synchronisierimpulse 9 und ihre Zuordnung zum Bit-Muster für die Datenbits der Betriebsparameter, die in Form von Impulsen 6 durch das Programmiergerät 8 erzeugt werden, ist der FIG 2 zu entnehmen. Das Impulsraster dient zur Erkennung der Programmzyklen und Auslesezyklen.

Im Betriebsfall dient der Freigabeeingang 2 zur Synchronisierung und zur externen Freigabesteuerung eines UltraschallKompakt-Näherungsschalters. Der Schaltausgang kann bis zu 300 mA belastet werden und ist kurzschluß- und überlastfest. Über die Anschlüsse 10, 11 können als Sonderfunktionen Betriebsparameter und Meßwerte ein- und ausgelesen werden. Diese Sonderfunktionen werden durch ein codiertes Zeitfenster 46 ausgelöst. Beim Einlesevorgang, d.h. bei der Programmierung muß nach dem codierten Zeitfenster 46 am Freigabeeingang 2 ein Überstromimpuls 45 durch das Programmiergerät 8 am Schaltausgang erzeugt werden.

Der Vorteil dieser Adressierung liegt in der Verknüpfbarkeit zur Freigabesteuerung. Sie ist mit wenig Programmaufwand im Mikroprozessor 4 realisierbar, der einen begrenzten Programmspeicher aufweist. Störuntersuchungen haben gezeigt, daß durch diese zeitliche Verschlüsselung keine ungewollten Ein- bzw. Auslesevorgänge ausgelöst werden. Über die Synchronisierimpulsdauer 13 wird auf den im vorliegenden Näherungsschalter verwendeten Ultraschall-Wandlertyp geschlossen. Daraufhin können die für diesen gültigen Betriebsparameter überprüft werden.

Die zeitcodierte Ansteuerung mit den Synchronisierimpulsen 9 erfolgt z.B. über die

Freigabe-Synchronisier-Leitung 31.

Dabei ist der Synchronisierimpuls 9 aus folgenden Zeitdauern zusammengesetzt.

```
Synchronisierdauer 13: Das Programmiergerät 8 synchronisiert
                       sich mit dem Ultraschall-Kompakt-Nä-
                       herungsschalter und das codierte Zeit-
                       fenster 46 wird mit steigender Flanke
                       des Synchronisierimpulses 9 ausgegeben.


                   Wartezeit 14   )   codiertes Zeit-⟋Programmiervorgang
Programmier-  Freigabezeit 15)    fenster 46 für⟍Auslesevorgang
                   Wartezeit 16   )
Datenbitübernahme 17:             Zeit bis zur fallenden Flanke,
                                  die die Datenbitübernahme aus-
                                  löst.
Datenbitquittierung 18:           Zeit bis zur steigenden Flan-
                                  ke, die die Datenbitübernahme
                                  quittiert.
```

Schaltausgang:

Datenbit-Freigabezeit 45:     während dieser Zeit wird ein definierter Überstrom von dem Programmiergerät 8 gezogen und so eine Datenbitübernahme eingeleitet.

Das beschriebene Verfahren zum Laden von Betriebsparametern in den Mikroprozessor 4 eines Näherungsschalters ist auch bei einem Ultraschall-Näherungsschalter 1 über seinen Freigabeeingang 2 in der im folgenden dargestellten Ausführungsform anwendbar, bei der zwischen dem Freigabeeingang 2 und dem Mikroprozessor 4 eine Synchronisiereinrichtung 22 zwischengeschaltet ist. Hier läßt sich über denselben Freigabeeingang 2 zudem noch eine parallele und serielle Synchronisation durchführen.

Diese Lösung ist daher bei Näherungsschaltern mit üblicherweise wenigen Anschlüssen vorteilhaft, wie z.B. bei Dreidraht-Kompaktschaltern mit einem Vierpolsteckeranschluß.

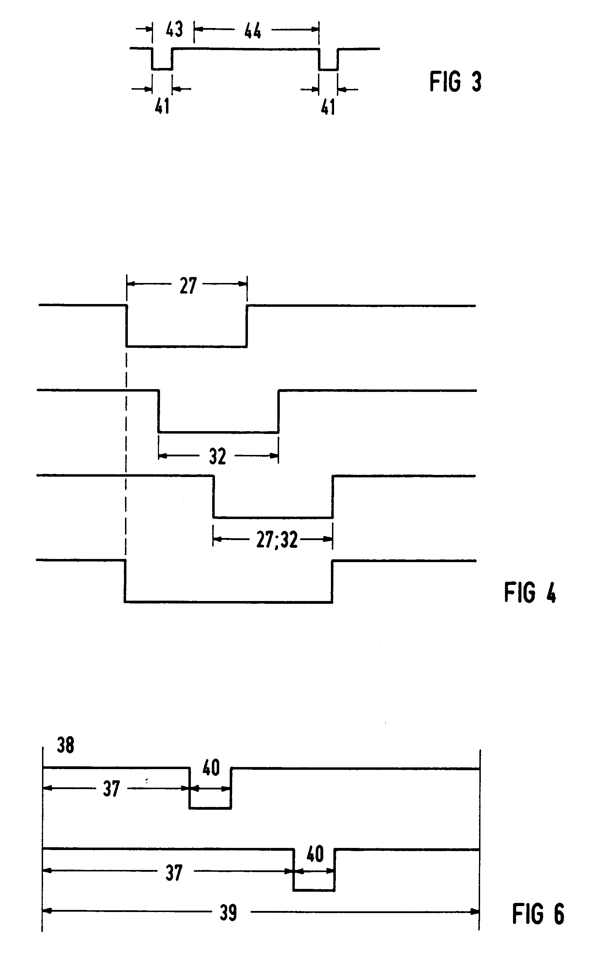

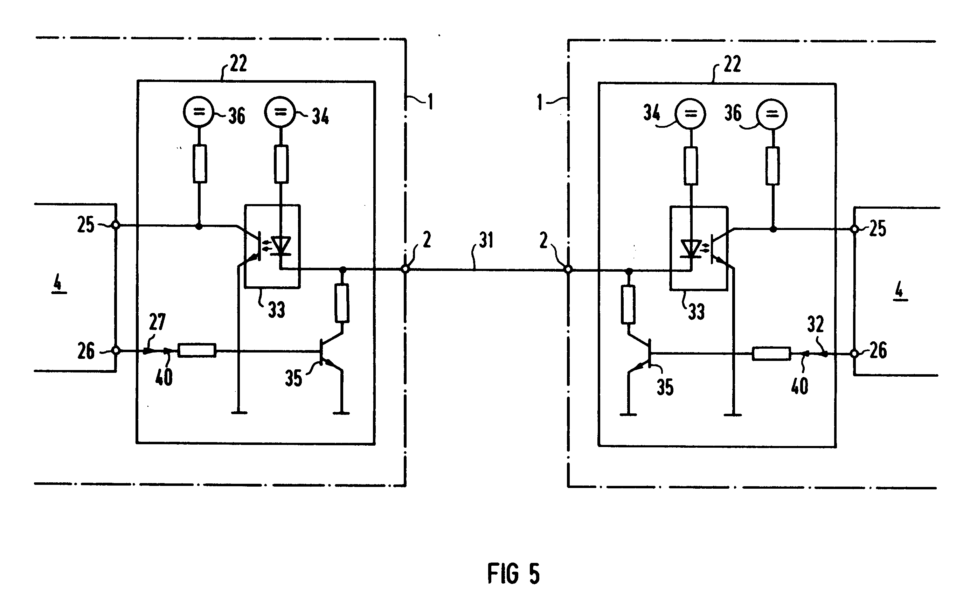

In Figur 3 ist ein Meßzyklus eines Näherungsschalters dargestellt, der mit der Ausgabe eines Sendeimpulses 41 von etwa 150 μs Dauer beginnt und der einen Erfassungsbereich 43 von z.B. 4,7 ms umfaßt, dem sich eine Auswertedauer 44 anschließt. Diese Auswertedauer 44 ist abhängig vom Gerätetyp unterschiedlich lang und schwankt in einem Bereich von z.B. 10 bis 14 ms. Dieser Schwankungsbereich hat zur Folge, daß selbst nach einer Parallelsynchronisation, d.h. nach dem gemeinsamen Absenden der Sendeimpulse von benachbarten Ultraschall-Näherungsschaltern der Meßzyklus für alle nicht zur gleichen Zeit beendet ist und somit erst abgewartet werden muß, bis jeder Ultraschall-Näherungsschalter zum Start eines neuen Meßzyklusses bereit ist. Hierzu erzeugt jeder Ultraschall-Näherungsschalter nach Beendigung der Auswertedauer 44 einen eigenen zweiten Synchronisierimpuls 27 bzw. 32, wobei die Länge der Synchronisierimpulse 27 bzw. 32 so gewählt ist, daß auf jeden Fall mindestens zwei Synchronisierimpulse 27 bzw. 32 sich zeitlich teilweise überlappen. In FIG 4 ist beispielhaft ein entsprechendes Raster mit Synchronisierimpulsen 27 bzw. 32 von drei Näherungsschaltern dargestellt. Der Synchronisierimpuls 27 bzw. 32 wird in dem Mikroprozessor 4 des Ultraschall-Näherungsschalters 1 erzeugt (siehe FIG 5). Benachbart betriebene Ultraschall-Näherungsschalter 1 sind über ihren Freigabeeingang 2 durch eine gemeinsame Leitung 31 miteinander verbunden. Zwischen dem Mikroprozessor 4 und dem Freigabeeingang 2 liegt eine Synchronisiereinrichtung 22. Der Mikroprozessor 4 gibt an seinem Ausgang 26 den Synchronisierimpuls 27 bzw. 32 an die Synchronisiereinrichtung 22 ab, die daraufhin einen Potentialwechsel der gemeinsamen Leitung 31 hervorruft, was zugleich eine entsprechende Rückmeldung an einem zweiten Eingang 25 des Mikroprozessors 4 im Ultraschall-Näherungsschalter 1 bewirkt. Dies bedeutet, daß der Potentialzustand auf der gemeinsamen Leitung 31 solange erhalten bleibt, wie zumindest noch ein zweiter Synchronisierimpuls 27 bzw. 32 ansteht, was in FIG 4 durch das unten dargestellte, aus allen zweiten Synchronisierimpulsen 27 bzw. 32 folgende Gesamtsignal ausgedrückt ist. Durch die erwähnte Rückmeldung des Potentialzustands der gemeinsamen Leitung 31 an den zweiten Eingang 25 vom Mikroprozessor 4 jedes Ultraschall-Näherungsschalters 1 wird somit die Information geliefert, daß noch nicht sämtliche Ultraschall-Näherungsschalter 1 an der gemeinsamen Leitung 31 zum Betrieb bereit sind. Erst nach Ablauf des letzten zweiten Synchronisierimpulses 27 bzw. 32 im Synchronisierimpulsraster geht die gemeinsame Leitung 31 auf einen anderen Potentialzustand über und zeigt daraufhin dem zweiten Eingang 25 des Mikroprozessors 4 an, daß für alle Ultraschall-Näherungsschalter 1 Sendebereitschaft besteht. Dieser letzte Potentialwechsel wird zur Einleitung der Sendeimpulse 41 bei Parallelsynchronisation verwendet. In FIG 5 sind zwei Ultraschall-Näherungsschalter 1 dargestellt, die über Ihren Freigabeeingang 2 durch eine gemeinsame Leitung 31 miteinander verbunden sind. In jedem Ultraschall-Näherungsschalter 1 befindet sich ein Mikroprozessor 4 mit einem zweiten Eingang 25 und einem Ausgang 26. Zwischen diesen Anschlüssen und dem Freigabeeingang 2 liegt eine Synchronisiereinrichtung 22 mit folgendem Aufbau. Zwischen dem Freigabeeingang 2 und dem Massepotential der Synchronisiereinrichtung 22 ist ein zweiter Transistor 35 geschaltet, der über den Ausgang 26 des Mikroprozessors 4 ansteuerbar ist und durch eine zweite Spannungsquelle 34 über einen Optokoppler 33 gespeist wird. Die Schaltstrecke des Optokopplers 33 liegt einerseits am zweiten Eingang 25 des Mikroprozessors 4 und über einen ohmschen Widerstand an einer dritten Spannungsquelle 36 sowie andererseits an dem Massepotential. Durch Anlegen eines im Mikroprozessor 4 erzeugten Synchronisierimpulses 27 bzw. 32 am Ausgang 26 wird der zweite Transistor 35 durchgeschaltet und damit die am Freigabeeingang 2 liegende Leitung 31 auf Massepotential gelegt. Mit dem Durchschalten des zweiten Transistors 35 wird zugleich der Optokoppler 33 durchgeschaltet und dadurch ebenfalls der zweite Eingang 25 des Mikroprozessors 4 auf Massepotential gelegt. Die Synchronisierimpulse 27bzw. 32 der miteinander verbundenen Ultraschall-Näherungsschalter 1 überlappen sich zeitlich mindestens teilweise, so daß an den zweiten Eingängen 25 der Mikroprozessoren 4 aller miteinander verbundenen Ultraschall-Näherungsschalter 1 solange Massepotential ansteht, wie dies auch für die gemeinsame Leitung 31 zutrifft, d. h. solange noch irgendein zweiter Synchronisierimpuls 27 bzw. 32 ansteht. Die Dauer ist in FIG 4 durch den aus den drei oberen Synchronisierimpulsen gebildeten unteren Gesamtimpuls wiedergegeben. Erst nachdem der zeitlich zuletzt auftretende zweite Synchronisierimpuls 27 abgelaufen ist, wird die gemeinsame Leitung 31 auf ein durch die zweite Spannungsquelle 34 bereitgestelltes High-Potential gelegt und damit zugleich auch ein High-Potential an jedem zweiten Eingang 25 von den Mikroprozessoren 4 bewirkt, das der dritten Spannungsquelle 36 entspricht. Durch diesen letzen Potentialwechsel am zweiten Eingang 25 ist die Information gegeben, daß sämtliche Ultraschall-Näherungsschalter 1 zum Senden bereit sind und daß nun der Sendeimpuls 41 (siehe FIG 3) zum gleichen Zeitpunkt abgegeben werden kann.

Stellt sich das Problem, daß unterschiedlich beabstandete Gegenstände mit benachbarten Ultraschall-Näherungsschaltern 1 erfaßt werden sollen, so ist hierfür der Betrieb mit serieller Synchronisation vorzunehmen. Der Meßzyklus eines Näherungsschalters 1 wird hierbei durch einen weiteren Meßzyklus eines anderen benachbarten Ultraschall-Näherungsschalters 1 abgelöst, so daß jeweils immer nur mit einem einzigen Ultraschall Näherungsschalter 1 eine Messung vorgenommen wird. Dabei werden Ultraschall-Näherungsschalter 1 mit dem für Parallelsynchronisation beschriebenen Aufbau verwendet. Auch bei der seriellen Synchronisation muß zunächst festgestellt werden, ob sämtliche an einer gemeinsamen Leitung angeschlossenen Ultraschall-Näherungsschalter 1 zum Betrieb bereit sind. Hierzu läuft, wie bei der Parallelsynchronisation, zunächst ein Synchronisierimpulsraster nach FIG 4 ab, wobei nun jedoch der Zustandswechsel am Ende des unteren Gesamtimpulses auf das High-Potential sowohl der gemeinsamen Leitung 31 als auch am zweiten Eingang 25 der Mikroprozessoren 4 als Startpunkt 38 benutzt wird (siehe FIG 6). Jeder Ultraschall-Näherungsschalter 1 erhält eine Adresse in Form eines Zeitabschnittes 37, der im Mikroprozessor 4 gespeichert ist und sozusagen als Kennung des jeweiligen Ultraschall-Näherungsschalters 1 dient. Ausgehend vom gemeinsamen Startpunkt 38 werden diese Zeitabschnitte 37 gemäß dem Impulsdiagramm nach Figur 6 gestartet. Am Ende jedes Zeitabschnittes 37, dessen Länge für den jeweiligen Ultraschall-Näherungsschalter 1 typisch ist, wird ein kurzer Prioritätenimpuls 40 abgegeben. Dabei sind die Adressen, d.h. die Zeitabschnitte 37 und die Dauer der Prioritätenimpulse 40 derart gewählt, daß die Prioritätenimpulse 40 sich zeitlich nicht überlappen. Mit dem Startpunkt 38 beginnt ein genügend groß gewähltes Zeitfenster 39 zu laufen, in dem in jedem Falle die Prioritätenimpulse 40 von allen benachbarten Ultraschall-Näherungsschaltern 1 liegen. Diese Prioritätenimpulse 40 werden, wie zuvor für die Parallelsynchronisation erläutert, im Mikroprozessor 4 erzeugt und von seinem Ausgang 26 an die Synchronisiereinrichtung 22 abgegeben und bewirken für die Dauer des Prioritätenimpulses 40 einen auf Masse führenden Potentialwechsel auf der gemeinsamen Leitung 31. Damit ist entsprechend der Beschreibung für die Synchronisierimpulse 27, 32 auch ein Potentialwechsel am zweiten Eingang 25 des Mikroprozessors 4 verbunden. Somit erhält jeder Mikroprozessor 4 über seinen zweiten Eingang 25 nicht nur die Information, wann im betreffenden Ultraschall-Näherungsschalter 1 ein Prioritätsimpuls 40 vorliegt, sondern auch über die gemeinsame Leitung 31 die Rückmeldung über die Prioritätsimpulse 40 von benachbarten Ultraschall-Näherungsschaltern 1. Auf diese Weise ist es möglich, daß jeder Ultraschall-Näherungsschalter 1 sich durch seinen Mikroprozessor 4 merkt, an wievielter Stelle nach dem Startpunkt 38 sein Prioritätsimpuls 40 abgegeben wurde. Am Ende des Zeitfensters 39 durchläuft daraufhin der Näherungsschalter mit dem zuerst abgegebenen Prioritätsimpuls 40 einen Meßzyklus und gibt einen Sendeimpuls 41 ab, während alle übrigen erst dann ihren Sendeimpuls 41 nacheinander freigeben, wenn sie entsprechend der selbstermittelten Reihenfolge an der Reihe sind. Die auf diese Weise durchgeführte serielle Synchronisation hat den großen Vorteil von äußerst geringen Verzögerungszeiten, da der Betrieb der Ultraschall-Näherungsschalter nicht unterbrochen sondern nur die Aussendung der Sendeimpulse gesperrt wird und somit auch keine unnötigen Resetzeiten zum zusätzlichen Zeitverzug führen. Der beschriebene Schaltungsaufbau, der nicht nur für den Betrieb der Parallelsynchronisation sondern auch zur seriellen Synchronisation geeignet ist, ist insbesondere bei Kompaktgeräten von Vorteil, bei denen im allgemeinen auf eine externe Steuerung verzichtet wird und ein kostengünstiger Geräteaufbau angestrebt wird. Derartige Kompaktgeräte werden üblicherweise nur mit einem Vierpolsteckeranschluß ausgestattet, so daß für Synchronisationszwecke nur noch ein Ausgang zur Verfügung steht. Der beschriebene Aufbau läßt jedoch auch den Betrieb mit einer externen Steuerung zu, die an die gemeinsame Leitung 31 anschließbar ist, um über diese von außen her einen Betrieb mit bestimmter Parallelsynchronisation oder serieller Synchronisation steuern können.

**Patentansprüche**

1. Verfahren zum Laden von Betriebsparametern in einen mit einer Überstrom-Überwachungseinrichtung (3) versehenen Näherungsschalter (1), wobei eine den Laststrom repräsentierende Größe einem Eingang eines Mikroprozessors (4) zugeführt wird und der Näherungsschalter einen Freigabeeingang (2) aufweist, der direkt oder über eine Synchronisiereinrichtung (22) mit einem weiteren Eingang des Mikroprozessors verbunden ist,
   **dadurch gekennzeichnet,**
   daß durch Simulation von Überstromzuständen über einen Lastanschluß (10,11) des Näherungsschalters (1) ein einen Betriebsparameter repräsentierender Impuls (6) als Bit-Muster erzeugt wird, der vom Mikroprozessor (4) zur Erkennung und Abspeicherung des Betriebsparameters ausgewertet wird, wobei der Freigabeeingang (2) zur Synchronisierung des dem Mikroprozessor (4) zugeführten Impulses (6) mittels Synchronisierimpulsen (9) benutzt wird.

2. Verfahren nach Anspruch 1,
   **dadurch gekennzeichnet,**
   daß die Simulation von Überstromzuständen mittels eines an den Lastanschluß (10,11) angeschlossenen Programmiergerätes(8) erfolgt.

**3.** Verfahren nach Anspruch 1 oder 2,
**dadurch gekennzeichnet,**
daß zur Ablegung der Betriebsparameter ein Festwertspeicher vorgesehen ist

**4.** Verfahren nach einem der vorangehendeen Ansprüche,
**dadurch gekennzeichnet,**
daß der Näherungsschalter als Ultraschall-Näherungsschalter (1) ausgeführt ist.

## Claims

**1.** Method for loading operating parameters into a proximity switch (1) which is provided with an overcurrent-monitoring device (3), by which a magnitude representing the load current is supplied to an input of a microprocessor (4) and the proximity switch has an enable input (2) which is connected directly or by way of a synchronizing device (22) to a further input of the microprocessor, characterised in that by means of simulation of overcurrent states by way of a load terminal (10, 11) of the proximity switch (1) a pulse (6) representing an operating parameter is generated as a bit pattern which is evaluated by the microprocessor (4) for the purpose of recognizing and storing the operating parameter, with the enable input (2) being used for the synchronization of the pulse (6), which is supplied to the microprocessor (4), by means of synchronizing pulses (9).

**2.** Method according to claim 1, characterised in that the simulation of overcurrent states is effected by means of a programming unit (8) connected to the load terminal (10, 11).

**3.** Method according to claim 1 or 2, characterised in that a read-only memory is provided for storing the operating parameters.

**4.** Method according to one of the preceding claims, characterised in that the proximity switch is realized as an ultrasonic proximity switch (1).

## Revendications

**1.** Procédé pour charger des paramètres de fonctionnement dans un interrupteur de proximité (1) équipé d'un dispositif (3) de contrôle de surintensité, selon lequel une grandeur représentant le courant de charge est envoyée à une entrée d'un microprocesseur (4), et l'interrupteur de proximité comporte une entrée d'autorisation (2), qui est raccordée directement ou par l'intermédiaire d'un dispositif de synchronisation (22) à une autre entrée du microprocesseur, caractérisé par le fait qu'au moyen d'une simulation d'états de surintensité, par l'intermédiaire d'une borne de charge (10,11) de l'interrupteur de proximité (1), on produit une impulsion (6) qui représente un paramètre de fonctionnement, sous la forme d'un profil binaire, qui est évalué par le microprocesseur (4) pour identifier et mémoriser le paramètre de fonctionnement, l'entrée d'autorisation (2) étant utilisée pour synchroniser l'impulsion (6), envoyée au microprocesseur (4), au moyen d'impulsions de synchronisation (9).

**2.** Procédé suivant la revendication 1, caractérisé par le fait que la simulation d'états de surintensité est réalisée au moyen d'un dispositif de programmation (8), qui est raccordé à la borne de charge (10,11).

**3.** Procédé suivant la revendication 1 ou 2, caractérisé par le fait qu'une mémoire morte est prévue pour la mémorisation des paramètres de fonctionnement.

**4.** Procédé suivant l'une des revendications précédentes, caractérisé par le fait que l'interrupteur de proximité est réalisé sous la forme d'un interrupteur de proximité à ultrasons (1).

FIG 1

EP 0 519 089 B1

FIG 2

EP 0 519 089 B1

EP 0 519 089 B1

FIG 3

FIG 4

FIG 6

FIG 5